# EUROPÄISCHE PATENTSCHRIFT

(11) **EP 1 099 883 B1**
(45) Veröffentlichungstag und Bekanntmachung des Hinweises auf die Patenterteilung: **05.07.2006**
(21) Anmeldenummer: 00122928.5
(22) Anmeldetag: 21.10.2000
(51) Int. Cl.: F16H 59/02, F16H 59/10, H03K 17/968

(54) **Vorrichtung zur Erkennung der Stellung eines Wahlhebels**
Device for recognizing the position of a selector lever
Dispositif pour la reconnaissance de la position d'un sélecteur

(30) Priorität: 10.11.1999 DE 19954173; 15.12.1999 DE 19960446
(43) Veröffentlichungstag der Anmeldung: 16.05.2001
(73) Patentinhaber: SIEMENS AKTIENGESELLSCHAFT, 80333 München (DE)
(72) Erfinder: Baltes, Andreas, 65843 Sulzbach (DE)

(56) Entgegenhaltungen:
- EP-A- 0 525 855
- EP-A- 0 844 418
- DE-C- 4 038 998
- US-A- 5 519 299

## Beschreibung

Die Erfindung betrifft eine Vorrichtung zur Erkennung der Stellung eines Wahlhebels, bei welcher der Wahlhebel mit einer Einrichtung verbunden ist, die bei eine gewünschte Stellung des Wahlhebels ein Signal an eine Auswerteeinrichtung ausgibt.

In vielen Anwendungsbereichen gibt es Wahlhebel, die in einer Richtung hin- und herbewegt werden können, in vorbestimmten Stellungen einrasten oder festlegbar sind und als Bedienungselemente die Funktion eines angeschlossenen Gerätes steuern. Es ist wünschenswert, die Wahlhebelstellung zu erfassen, um ein System, in das das durch den Wahlhebel gesteuerte Gerät eingebunden ist, besser steuern zu können. Im Kraftfahrzeug ist die Information, welche Getriebestufe gewählt worden ist, beispielsweise für eine automatische Geschwindigkeitssteuerung notwendig.

Gemäß US 4,523,373 ist ein Betätigungshebel mit einem Potentiometer bekannt, wobei am Potentiometer immer eine der Stellung des Wahlhebels entsprechende Spannung abgreifbar ist. Das Potentiometer ist so in einem Gehäuse eingebaut, daß bei einer vorgewählten Hebelstellung immer die gleiche Signalspannung abgegeben wird. Solche kontaktgesteuerten Positionserkennungen unterliegen durch Abrieb und Verschmutzung einem Verschleiß, was zu Folge hat, daß die einer bestimmten Position des Wahlhebels entsprechende Signalspannung über die Lebensdauer des Potentiometers variiert. Eine eindeutige Zuordnung der Spannung zu der Position des Wahlhebels ist nicht mehr gegeben.

Die gattungsbildende DE 40 38 998 C1 offenbart eine Vorrichtung zur Erfassung der Fehlstellung eines Betätigungshebels, bei der eine zugehörige Getriebeschaltstange eine fahnenförmige Blende, die bei Fehlstellungen des Betätigungshebels den Meßstrahl eines Sensorfeldes unterbricht oder reflektiert und beim gleichzeitigen Vorliegen einer weiteren Bedingung für den Stillstand eines Kraftfahrzeuges das Ausrücken einer zum Schaltgetriebe führenden Trennkupplung bewirkt oder eine Anlaßsperre auslöst. An Blenden benachbarter Schaltstangen läßt sich durch unterschiedlich große oder geformte Durchtrittsöffnungen im Lichtschrankenprinzip oder durch Reflexionsabtastung feststellen, welcher der Betätigungshebel bei stillstehendem Fahrzeug in Fehlstellung eingelegt ist. Das Sensorfeld kann optisches Licht oder IR-Strahlung und durch optische Halbleitersensoren, Photodioden, LED-Leuchtdioden meßbar sein; es kann ein Magnetfeld und durch galvanomagnetische Bauelemente, analoge oder digitale Hallsensoren oder magnetoresistive Sensoren meßbar sein. Der Wahlhebel mit einer im Strahlengang zwischen einem optischen Sender und einem optischen Empfänger angeordneten Blende verbunden ist, wobei die Blende der Bewegung des Wahlhebels folgend bei der gewünschten Stellung des Wahlhebels optisch durchlässig gestaltet ist, wodurch der optische Empfänger das Signal des optischen Senders empfängt und an die Auswerteeinrichtung weiterleitet. Der Erfindung liegt die Aufgabe zugrunde, eine Vorrichtung zur Erkennung der Stellung eines Wahlhebels anzugeben, welche über die gesamte Lebensdauer zuverlässig arbeitet und kostengünstig herstellbar ist. Erfindungsgemäß wird die Aufgabe dadurch gelöst, daß eine Erfassung der Stellung des Wahlhebels eindeutig gewährleistet wird, und daß für jede zu bestimmende Stellung des Wahlhebels ein optischer Empfänger vorhanden ist und bei Bewegen des Wahlhebels eine Öffnung der Blende über den optischen Empfängern verschoben wird. Weiterhin wird eine eindeutige Erfassung der Stellung des Wahlhebels gewährleistet.

Der Vorteil der Erfindung besteht in der kontaktlosen Positionserkennung. Die Schalteinrichtung des Wahlhebels arbeitet somit vollständig verschleißlos. Sie ist konstruktiv einfach und ausreichend robust für den Einsatz in einem Kraftfahrzeug.

Für eine für die Anwendung in Kraftfahrzeugen besonders robuste Ausführung sind die optischen Empfänger dem Bewegungsablauf des Wahlhebels entsprechend auf einem Trägerelement fest angeordnet.

Durch die Anordnung der mit dem optischen Empfänger verbundenen Auswerteeinrichtung auf demselben Trägerelement, wird eine besonders kompakte und kleine Schalteinrichtung erreicht.

In einer Ausgestaltung ist mindestens ein optischer Sender auf dem Trägerelement angeordnet, dessen optisches Signal mittels eines Lichtleiters auf die Blende umlenkbar ist. Eine solche Einrichtung ist flexibel an jedem beliebigen Einbauort einsetzbar.

Um die Bewegung des Wahlhebels in unterschiedliche Bewegungsrichtungen eindeutig erfassen zu können, ist für jede Bewegungsrichtung des Wahlhebels eine Blende vorgesehen. Dabei sind die Blenden mechanisch voneinander entkoppelt bewegbar. Aufgrund dieser Anordnung werden alle Positionen sowohl in der horizontalen und/oder vertikalen Bewegungsrichtung des Wahlhebels zuverlässig erfaßt.

Vorteilhafterweise weist die dem Wahlhebel in annähernd vertikaler Richtung folgende zweite Blende zwei optisch durchlässige Öffnungen auf, wobei die annähernd vertikale Bewegung des Wahlhebels in eine kreisbogenähnliche Bewegung der Blende umgesetzt wird.

Zur gleichmäßigen Verteilung des optischen Signales über den Blenden ist der Lichtleiter flächig ausgebildet.

Die Erfindung läßt zahlreiche Ausführungsformen zu. Eine davon soll anhand der in der Zeichnung dargestellten Figuren näher erläutert werden. Es zeigt:
- Figur 1:: erfindungsgemäße Vorrichtung,
- Figur 2:: Anordnung der optischen Empfänger auf einer Leiterplatte,
- Figur 3:: Anordnung der optischen Elemente der Vorrichtung nach Figur 1.

Gleiche Merkmale sind mit gleichen Bezugszeichen gekennzeichnet.

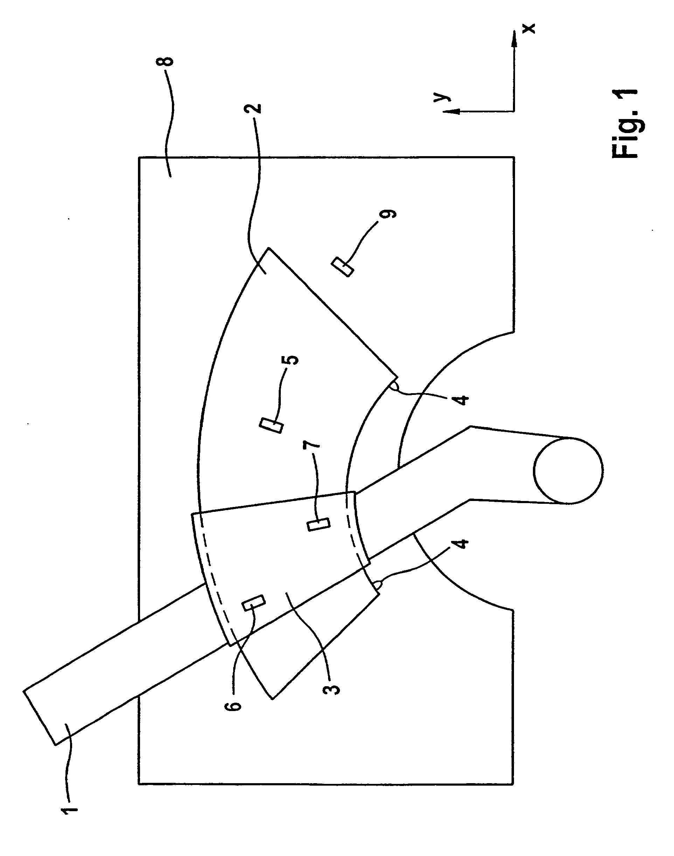

In Figur 1 ist schematisch die erfindungsgemäße Lösung zur Erkennung der Stellung eines Wahlhebels dargestellt, wie sie in einem Automatikgetriebe eines Kraftfahrzeuges einsetzbar ist. Der Wahlhebel kann in verschiedenen Stellungen einrasten, wodurch unterschiedliche Getriebestufen festlegt werden, nämlich Parken, Rückwärtsfahren, Leerlauf und 3 Vorwärtsfahrstufen.

Der Wahlhebel 1 ist dabei über eine nicht weiter dargestellte Mechanik mit einer ersten Blende 2 und einer zweiten Blende 3 verbunden. Die erste Blende 2 folgt dem Wahlhebel 1, wenn dieser annähernd in linearer Richtung bewegt wird (x-Richtung). Wird der Wahlhebel 1 senkrecht zur x-Richtung bewegt, wird die Blende 2 durch Blockierungen 4 in ihrer Position gehalten und nur die Blende 3 folgt der Bewegung des Wahlhebels 1.

Die Blende 2 weist dabei eine Öffnung 5 auf, während die Blende 3 zwei vertikal gegeneinander versetzte Öffnungen 6 und 7 trägt. Auf einer Leiterplatte 8 sind optische Empfänger angeordnet, von denen nur ein optischer Empfänger 9 dargestellt ist.

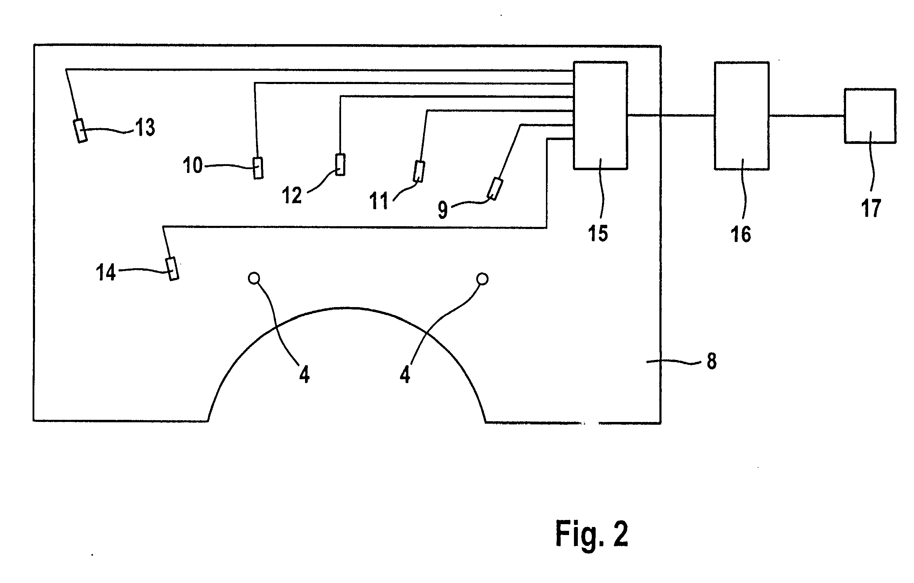

Die Anordnung aller Infrarotempfänger auf der Leiterplatte 8 ist in Figur 2 dargestellt. Vier Infrarotempfänger 9, 10,11, 12 dienen als Detektor für die Bewegung des Wahlhebels 1 in x-Richtung. Sie sind so auf der Leiterplatte positioniert, daß sie bei Bewegung der Blende 2 durch den Wahlhebel 1 vollständig von der Öffnung 5 dieser Blende 2 nacheinander überstrichen werden.

Darüber hinaus sind auf der Leiterplatte 8 vertikal die Infrarotdioden 13, 14 angeordnet, welche die Bewegung des Wahlhebels 1 in vertikaler Richtung (y-Richtung) detektieren und den Öffnungen 6 und 7 der Blende 3 zugeordnet sind.

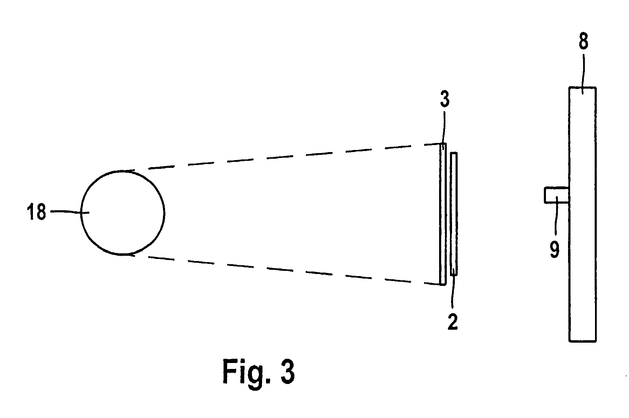

Alle Infrarotdioden 9 bis 14 sind mit einer Auswerteschaltung 15 verbunden, die ebenfalls auf der Leiterplatte 8 angeordnet ist. Die Empfängerdioden 9 bis 14 wandeln das von einem optischen Sender 18 (Figur 3) ausgesandte optische Signal in ein elektrisches Signal um, welches von der Auswerteeinrichtung 15 ausgewertet wird. In Abhängigkeit des von der Auswerteeinrichtung 15 gelieferten Signales steuert eine Getriebesteuereinrichtung 16, welche elektrisch mit der Auswerteeinrichtung 15 verbunden ist, ein Getriebe 17 an.

In Figur 3 sind noch einmal schematisch die optischen Elemente der Schalteinrichtung dargestellt. Eine Lichtquelle 18, beispielsweise ebenfalls eine Infrarotdiode, die der Einfachheit halber auch auf der Leiterplatte 8 angeordnet ist, beleuchtet die Blenden 2 und 3 flächig. Hinter den Blenden 2, 3 sind, wie bereits erläutert, auf der Leiterplatte 8 die Empfänger 9, 10, 11, 12, 13, 14 angeordnet, wobei in dieser Darstellung nur der Empfänger 9 gekennzeichnet ist.

Die erfindungsgemäße Vorrichtung arbeitet wie folgt:

Da der Wahlhebel 1 mit der Blende 2 mechanisch verbunden ist, folgt beim Einlegen der Vorwärtsgänge bzw. des Leerlaufes die Blende 2 der Bewegung des Wahlhebels 1. Dabei wird die Öffnung 5 der Blende 2 über die Leuchtdioden 9, 10, 11, 12 bewegt. Die Empfängerdioden 9, 10, 11, 12 sind dabei so auf der Leiterplatte 8 positioniert, daß ihre Position jeweils einer eingerasteten Stellung des Wahlhebels 1 entspricht. Gibt die Öffnung 5 der Blende 2 eine der Empfängerdioden 9, 10, 11, 12 frei, wird eine eindeutige Signalkombination an die Auswerteeinrichtung 15 abgegeben. Dadurch kann die Auswerteeinrichtung 15 feststellen, in welcher Position sich der Wahlhebel 1 befindet. Bei der Bewegung der Blende 2 verharrt die Blende 3 in ihrer voreingestellten Stellung, welche so gewählt ist, daß die Öffnung 5 der Blende 2 durch die Blende 3 nicht beeinflußt wird.

Nur wenn die Öffnung 5 der Blende 2 den optischen Empfänger der vorgegebenen Position des Wahlhebels 1 vollständig freigibt, wird die Stellung des Wahlhebels 1 bewertet. Eine solche Bewertung ist in der Auswerteelektronik 15 einfach durch Erfassung der Lichtleistung möglich, welche vom Empfänger geliefert wird. Durch eine Schwellwertbetrachtung des vom Empfänger gelieferten Signales wird eine zuverlässige Auswertung gewährleistet.

Soll nun beispielsweise ein Rückwärtsgang eingelegt werden, welcher bekannter weise durch eine Bewegung des Wahlhebels 1 in y-Richtung erfolgt, verhindern Anschläge 4, die unterhalb der Blende 2 angeordnet sind, die Bewegung der Blende 2 in diese Richtung. In diesem Fall folgt nur die Blende 3 der Bewegung des Wahlhebels 1. Die Blende 3 weist dabei die Öffnungen 6 und 7 auf, die mit der Empfängerdiode 13 bzw. 14 auf der Leiterplatte 8 in Übereinstimmung gebracht werden müssen. Durch eine entsprechende Mechanik wird die senkrechte Bewegung des Wahlhebels 1 in eine annähernd kreisbogenähnliche Bewegung der Blende 3 umgesetzt, wobei diese kreisbogenähnliche Bewegung der Blende 3 entgegengesetzt der kreisbogenähnlichen Bewegung der Blende 2 verläuft.

Durch die vertikale Bewegung des Wahlhebels 1 wird die Öffnung 7 der Blende 3 mit der Empfängerdiode 14 in Übereinstimmung gebracht, wodurch die Auswerteeinrichtung 15 erkennt, daß eine senkrechte Bewegung des Wahlhebels 1 erfolgt ist und der Rückwärtsgang eingelegt werden soll.

Erreicht der Wahlhebel 1 die gewünschte Parkstellung, gibt die Öffnung 6 der Blende 3 die Empfängerdiode 13 frei, womit der Auswerteeinrichtung 15 signalisiert wird, daß die gewünschte Position erreicht ist.

## Patentansprüche

1. Vorrichtung zur Erkennung der Stellung eines Wahlhebels, bei welcher der Wahlhebel mit einer Einrichtung verbunden ist, die bei einer gewünschten Stellung des Wahlhebels ein Signal an eine Auswerteeinrichtung ausgibt, wobei der Wahlhebel (1) mit einer im Strahlengang zwischen einem optischen Sender (18) und einem optischen Empfänger (9, 10, 11, 12, 13, 14) angeordneten Blende (2,3) verbunden ist, wobei die Blende (2, 3) der Bewegung des Wahlhebels (1) folgend bei der gewünschten Stellung des Wahlhebels (1) optisch durchlässig gestaltet ist, wodurch der optische Empfänger (9, 10, 11, 12, 13, 14) das Signal des optischen Senders (18) empfängt und an die Auswerteeinrichtung (15) weiterleitet, **dadurch gekennzeichnet, daß** für jede zu bestimmende Stellung des Wahlhebels (1) ein optischer Empfänger (9, 10, 11, 12, 13, 14) vorhanden ist und bei Bewegen des Wahlhebels (1) eine Öffnung (5, 6, 7) der Blende (2 ,3) über den optischen Empfängern (9, 10, 11, 12, 13, 14) verschoben wird.

2. Vorrichtung nach Anspruch 1, **dadurch gekennzeichnet, daß** die optischen Empfänger (9, 10, 11, 12, 13, 14) entsprechend dem Bewegungsablauf des Wahlhebels (1) auf einem Trägerelement (8) fest angeordnet sind.

3. Vorrichtung nach Anspruch 2, **dadurch gekennzeichnet, daß** die mit den optischen Empfängern (9, 10, 11, 12, 13, 14) verbundene Auswerteeinrichtung (15) auf dem Trägerelement (8) angeordnet ist.

4. Vorrichtung nach Anspruch 2, **dadurch gekennzeichnet, daß** mindestens ein optischer Sender (18) auf dem Trägerelement (8) angeordnet ist, dessen optisches Signal mittels eines Lichtleiters auf die Blende (2, 3) umlenkbar ist.

5. Vorrichtung nach Anspruch 1, **dadurch gekennzeichnet, daß** für jede Bewegungsrichtung des Wahlhebels (1) eine Blende (2, 3) vorhanden ist.

6. Vorrichtung nach Anspruch 5, **dadurch gekennzeichnet, daß** die Blenden (2, 3) mechanisch voneinander entkoppelt bewegbar sind.

7. Vorrichtung nach Anspruch 6, **dadurch gekennzeichnet, daß** die dem Wahlhebel (1) in annähernd vertikaler Richtung (y) folgende zweite Blende (3) zwei optisch durchlässige Öffnungen (6, 7) aufweist, wobei die vertikale Bewegung des Wahlhebels (1) in eine kreisbogenähnliche Bewegung der Blende (3) umgesetzt wird.

8. Vorrichtung nach Anspruch 4, 5 und 7, **dadurch gekennzeichnet, daß** der Lichtleiter zur gleichmäßigen Verteilung des optischen Signals über den Blenden (2, 3) flächig ausgebildet ist.

## Claims

1. Device for detecting the position of a selector lever, in which the selector lever is connected to a device that emits a signal to an evaluation device in a desired position of the selector lever, the selector lever (1) being connected to a diaphragm (2, 3) arranged in the beam path between an optical transmitter (18) and an optical receiver (9, 10, 11, 12, 13, 14), the diaphragm (2, 3), which follows the movement of the selector lever (1), being designed in such a way as to be optically transparent in the desired position of the selector lever (1), as a result of which the optical receiver (9, 10, 11, 12, 13, 14) receives the signal from the optical transmitter (18) and transmits it to the evaluation device (15), **characterized in that** there is an optical receiver (9, 10, 11, 12, 13, 14) for each position of the selector lever (1) to be determined, and an opening (5, 6, 7) in the diaphragm (2, 3) is moved over the optical receivers (9, 10, 11, 12, 13, 14) when the selector lever (1) is moved.

2. Device according to Claim 1, **characterized in that** the optical receivers (9, 10, 11, 12, 13, 14) are arranged in a fixed manner on a carrier element (8) in accordance with the sequence of motion of the selector lever (1).

3. Device according to Claim 2, **characterized in that** the evaluation device (15) connected to the optical receivers (9, 10, 11, 12, 13, 14) is arranged on the carrier element (8).

4. Device according to Claim 2, **characterized in that** at least one optical transmitter (18) is arranged on the carrier element (8), the optical signal of which can be deviated onto the diaphragm (2, 3) by means of a light guide.

5. Device according to Claim 1, **characterized in that** there is one diaphragm (2, 3) for each direction of motion of the selector lever (1).

6. Device according to Claim 5, **characterized in that** the diaphragms (2, 3) can be moved in mechanical isolation from one another.

7. Device according to Claim 6, **characterized in that** the second diaphragm (3), which follows the selector lever (1) in an approximately vertical direction (y), has two optically transparent openings (6, 7), the vertical movement of the selector lever (1) being converted into a circular-arc-like movement of the diaphragm (3).

8. Device according to Claim 4, 5 and 7, **characterized in that** the light guide is designed to cover an extended area to ensure uniform distribution of the optical signal over the diaphragms (2, 3).

## Revendications

1. Dispositif permettant de reconnaître la position d'un levier de sélection, où le levier de sélection est relié à un système qui envoie, dans une position recherchée du levier de sélection, un signal à un système d'évaluation, où le levier de sélection (1) est lié à un masque (2, 3) disposé sur le trajet du faisceau de rayons entre un émetteur optique (18) et un récepteur optique (9, 10, 11, 12, 13, 14), où le masque (2, 3), en suivant le mouvement du levier de sélection (1), devient optiquement transparent dans la position recherchée du levier de sélection (1), si bien que le récepteur optique (9, 10, 11, 12, 13, 14) reçoit le signal de l'émetteur optique (18) et le retransmet au système d'évaluation (15), **caractérisé en ce que**, pour chaque position du levier de sélection (1) à déterminer, il y a un récepteur optique (9, 10, 11, 12, 13, 14) et que, lors d'un déplacement du levier de sélection (1), un trou (5, 6, 7) du masque (2, 3) est déplacé au-dessus des récepteurs optiques (9, 10, 11, 12, 13, 14).

2. Dispositif selon la revendication 1 **caractérisé en ce que** les récepteurs optiques (9, 10, 11, 12, 13, 14) sont montés à demeure sur un élément porteur (8) en fonction du parcours du levier de sélection (1).

3. Dispositif selon la revendication 2 **caractérisé en ce que** le système d'évaluation (15) relié aux récepteurs optiques (9, 10, 11, 12, 13, 14) est monté sur l'élément porteur (8).

4. Dispositif selon la revendication 2 **caractérisé en ce que** au moins un émetteur optique (18) est monté sur l'élément porteur (8) et que son signal optique peut être orienté vers le masque (2, 3) au moyen d'un guide d'ondes optiques.

5. Dispositif selon la revendication 1 **caractérisé en ce que**, pour chaque direction de déplacement du levier de sélection (1), il y a un masque (2, 3).

6. Dispositif selon la revendication 5 **caractérisé en ce que** les masques (2, 3) peuvent se déplacer sans être couplés mécaniquement les uns aux autres.

7. Dispositif selon la revendication 6 **caractérisé en ce que** le deuxième masque (3), qui suit le levier de sélection (1) dans la direction approximativement verticale (y), comporte deux trous optiquement transparents (6, 7), le mouvement vertical du levier de sélection (1) étant converti en un mouvement du masque en arc de cercle.

8. Dispositif selon la revendication 4, 5 et 7 **caractérisé en ce que** le guide d'ondes optiques est configuré en nappe pour assurer la répartition régulière du signal optique au-dessus des masques (2, 3).
